# EUROPEAN PATENT SPECIFICATION

(11) **EP 1 121 006 B1**
(45) Date of publication and mention of the grant of the patent: **03.10.2007**
(21) Application number: 00311220.8
(22) Date of filing: 15.12.2000
(51) Int. Cl.: H05K 3/34, H05K 9/00

(54) **Transmitter-receiver unit that ensures mounting of a cover on a metallic frame**
Sende-Empfangseinheit zur Sicherstellung der Montage einer Abdeckung auf einem Metallrahmen
Unité émettrice-réceptrice permettant d'assurer le montage d'un couvercle sur un chassis métallique

(30) Priority: 24.01.2000 JP 2000017951
(43) Date of publication of application: 01.08.2001
(73) Proprietor: ALPS ELECTRIC CO., LTD., Ota-ku Tokyo 145 (JP)
(72) Inventor: Watanabe, Yoshikiyo, Alps Electric Co., Ltd., Tokyo 145 (JP)
(74) Representative: Kensett, John Hinton

(56) References cited:
- EP-A- 0 765 010
- WO-A-98/08366
- DE-A- 3 233 620
- PATENT ABSTRACTS OF JAPAN vol. 1995, no. 09, 31 October 1995 (1995-10-31) -& JP 07 147495 A (NEC CORP), 6 June 1995 (1995-06-06)
- PATENT ABSTRACTS OF JAPAN vol. 018, no. 066 (E-1501), 3 February 1994 (1994-02-03) & JP 05 283887 A (TOSHIBA LIGHTING & TECHNOL CORP), 29 October 1993 (1993-10-29)
- PATENT ABSTRACTS OF JAPAN vol. 018, no. 372 (E-1577), 13 July 1994 (1994-07-13) & JP 06 104366 A (KAWASAKI STEEL CORP), 15 April 1994 (1994-04-15)
- PATENT ABSTRACTS OF JAPAN vol. 014, no. 117 (E-0898), 5 March 1990 (1990-03-05) & JP 01 315167 A (OKI ELECTRIC IND CO LTD), 20 December 1989 (1989-12-20)

## Description

### BACKGROUND OF THE INVENTION

### Field of the Invention:

The present invention relates to a transmitter-receiver unit used in a portable telephone.

### Description of the Related Art:

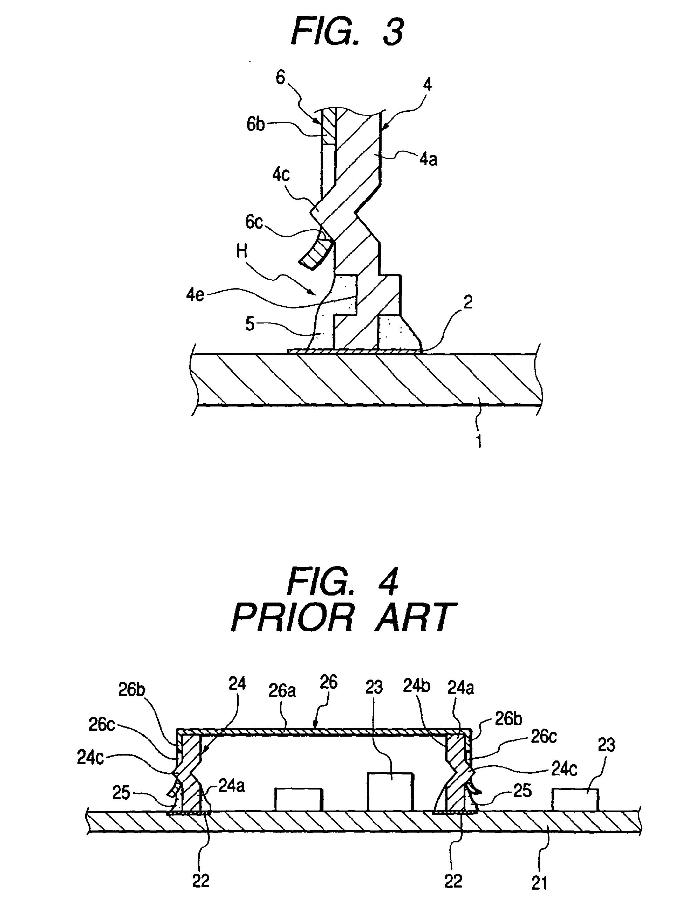

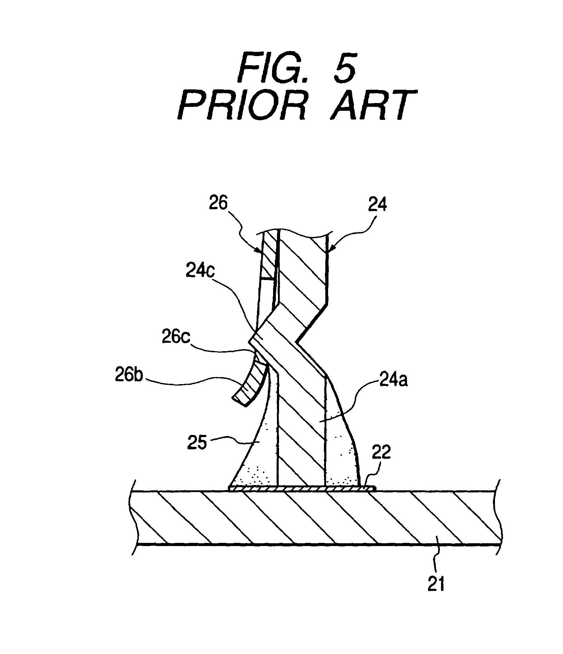

A conventional transmitter-receiver unit will now be described with reference to Figs. 4 and 5. On an upper surface of a circuit board 21 which is a printed circuit board there are formed electrically conductive patterns 22, and electric components 23 such as resistors, capacitors and IC parts are put on the upper surface of the circuit board 21 and are soldered to the conductive patterns 22 to form a desired circuit.

A frame 24, which is formed in a rectangular shape using a metal, comprises four side walls 24a and upper and lower openings 24b. The frame 24 is further provided with a plurality of retaining portions 24c on the side walls 24a, the retaining portions 24c being formed by sticking out the frame 24 outwards from the interior.

A circuit portion which includes desired electric components 23 on the circuit board 21 is positioned inside the frame 24 and in this state a lower end portion of the frame 24 is put on the circuit board 21 and is soldered at 25 throughout the whole circumference thereof to the conductive patterns 22. Thus, the frame 24 is surface-mounted onto the circuit board 21.

A metallic cover 26, which is in the shape of a rectangular box, has a flat plate-like upper surface portion 26a, mounting pieces 26b bent from the four sides of the upper surface portion 26a, and engaging holes 26c formed in the vicinity of end portions of the mounting pieces 26b.

The upper surface portion 26a of the cover 26 covers the upper opening 24b of the frame 24, and with the mounting pieces 26b positioned on outer surfaces of the side walls 24a, the engaging holes 26c are fitted on the retaining portions 24c, whereby the cover 26 is mounted to the frame 24. Thus, the desired circuit portion is shielded electrically by both cover 26 and frame 24.

The conventional transmitter-receiver unit is constructed as above. In the same unit, for mounting the frame 24 to the circuit board 21, first the lower end portion of the frame 24 is put on creamy solder (not shown) applied onto the conductive patterns 22 and then the circuit board 21 with the frame 24 thereon is conveyed into a heating furnace to melt the creamy solder, allowing the lower end portion of the frame 24 and the conductive patterns 22 to be soldered at 25.

In the conventional frame 24, however, the surfaces of the side walls 24a between the retaining portions 24c and the circuit board 21 are straight surfaces, so upon melting of the creamy solder, the solder 25 rises up to the retaining portions 24c, as shown in Figs. 4 and 5, so that the engagement between the engaging holes 26c and the retaining portions 24c becomes shallow and insufficient and the cover 26 may become disengaged from the frame 24 or it may be impossible to effect the engagement of the cover with the frame.

Particularly in the case of a portable telephone, since the reduction of size and weight is required, an attempt to reduce the height of the frame 24 for the attainment of size and weight reduction encounters the necessity of shortening the length of the side walls 24a between the retaining portions 24c and the circuit board 21, resulting in that the rise of the solder 25 up to the retaining portions 24c becomes more marked and the engagement between the engaging holes 26c and the retaining portions 24c becomes shallower and insufficient or may become impossible.

### SUMMARY OF THE INVENTION

Accordingly, it is an object of the present invention to provide a transmitter-receiver unit which ensures mounting of a cover to a frame and which is suitable for the reduction of size and weight.

For achieving the above-mentioned object, according to the present invention there is provided a transmitter-receiver unit comprising a circuit board having electrically conductive patterns, a metallic frame having retaining portions, the metallic frame being put and surface-mounted onto the circuit board, and a cover which covers an upper opening of the frame and which is engaged with the retaining portions. The frame is provided with solder-rise preventing means between the circuit board and the retaining portions.

According to the first prefered embodiment adopted by the present invention there is provided a transmitter-receiver unit wherein the solder-rise preventing means are formed by convex portions provided on the frame.

According to the second prefered embodiment adopted by the present invention there is provided a transmitter-receiver unit wherein the solder-rise preventing means are formed by concave portions provided in the frame.

### BRIEF DESCRIPTION OF THE DRAWINGS

Fig. 1 is a sectional view of a transmitter-receiver unit according to the first embodiment of the present invention;
Fig. 2 is an enlarged sectional view of a principal portion thereof;
Fig. 3 is an enlarged sectional view of a principal portion of a transmitter-receiver unit according to the second embodiment of the present invention;
Fig. 4 is a sectional view of a conventional transmitter-receiver unit; and
Fig. 5 is an enlarged sectional view of a principal portion thereof.

### DETAILED DESCRIPTION OF THE PREFERRED EMBODIMENTS

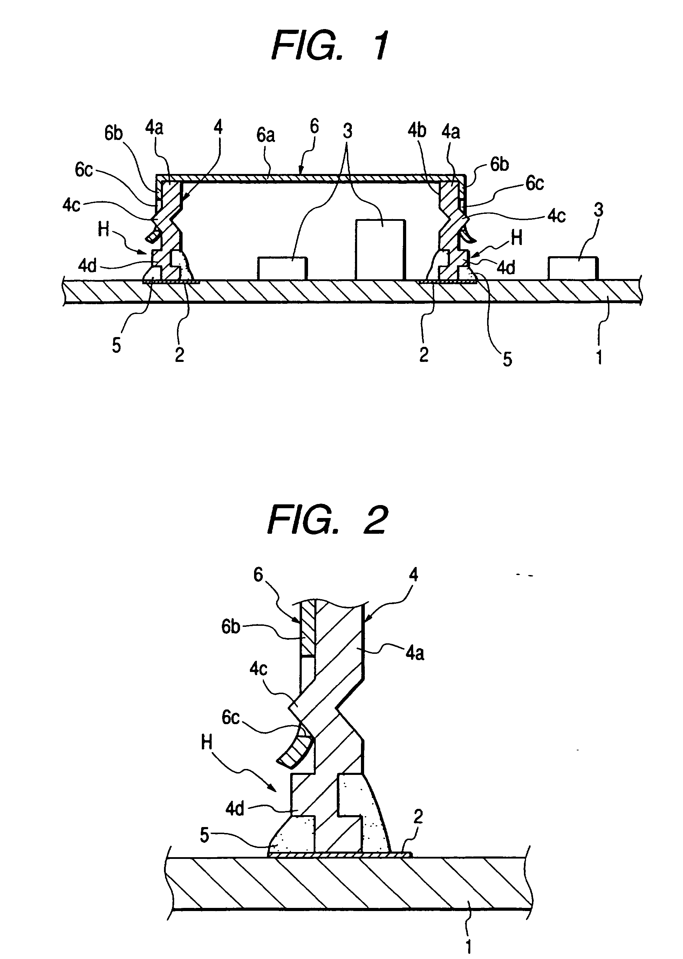

Transmitter-receiver units embodying the present invention will be described hereinunder with reference to the accompanying drawings, in which Fig. 1 is a sectional view of a transmitter-receiver unit according to the first embodiment of the invention, Fig. 2 is an enlarged sectional view of a principal portion thereof, and Fig. 3 is an enlarged sectional view of a principal portion of a transmitter-receiver unit according to the second embodiment of the invention.

The construction of the transmitter-receiver unit according to the first embodiment of the invention will now be described with reference to Figs. 1 and 2. Electrically conductive patterns 2 are formed on an upper surface of a circuit board 1 which is a printed circuit board and electric components 3 such as resistors, capacitors and IC parts are put on the upper surface of the circuit board 1 and are soldered to the conductive patterns 2 to form a desired circuit.

A metallic frame 4, which is formed in a rectangular shape, comprises four side walls 4a and upper and lower openings 4b. The frame 4 is also provided with a plurality of retaining portions 4c on the side walls 4a, the retaining portions 4c being formed by sticking out the frame 4 outwards from the interior.

The frame 4 is further provided with a plurality of convex portions 4d between the lower end portions of the side walls 4a of the frame 4 and the retaining portions 4c, thereby constituting a plurality of solder-rise preventing means H, the convex portions 4d being formed by sticking out the frame 4 outwards from the interior.

A circuit portion which includes desired electric components 3 on the circuit board 1 is positioned inside the frame 4 and in this state a lower end portion of the frame 4 is put on the circuit board 1 and is soldered at 5 throughout the whole circumference thereof to the conductive patterns 2. Thus, the frame 4 is surface-mounted onto the circuit board 1.

A metallic cover 6, which is in the shape of a metallic box, has a flat plate-like upper surface portion 6a, mounting pieces 6b bent from the four sides of the upper surface portion 6a, and engaging holes 6c formed in the vicinity of end portions of the mounting pieces 6b.

The upper surface portion 6a of the cover 6 covers the upper opening 4b of the frame 4, and with the mounting pieces 6b positioned on outer surfaces of the side walls 4a, the engaging holes 6c are fitted on the retaining portions 4c, whereby the cover 6 is mounted to the frame 4. Thus, the desired circuit portion is shielded electrically by both cover 6 and frame 4.

For mounting the frame 4 to the circuit board 1 in the transmitter-receiver unit of this embodiment, first the lower end portion of the frame 4 is put on creamy solder (not shown) applied onto the conductive patterns 2 and then the circuit board 1 with the frame 4 thereon is conveyed into a heating furnace to melt the creamy solder, allowing the lower end portion of the frame 4 and the conductive patterns 2 to be soldered at 5.

In the frame 4 of this embodiment, since solder-rise preventing means H are formed between the retaining portions 4c and the circuit board 1, the rise of the solder 5 is prevented by the solder-rise preventing means H upon melting of the creamy solder and the solder 5 does not reach the retaining portions 4c, as shown in Figs. 1 and 2. Consequently, the engagement between the engaging holes 6c and the retaining portions 4c is ensured and there is no fear of disengagement of the cover 6 nor is there any fear of the cover becoming unengageable.

Particularly, even if the side walls 4a between the retaining portions 4c and the circuit board 1 are made shorter to meet the requirement for the reduction of size and weight of a portable telephone, the rise of the solder 5 up to the retaining portions 4c is prevented by the solder-rise preventing means H and the solder 5 does not reach the retaining portions 4c, thus ensuring the engagement between the engaging holes 6c and the retaining portions 4c.

Referring now to Fig. 3, there is illustrated a transmitter-receiver unit according to the second embodiment of the present invention. In this second embodiment, between the lower end portion of the side walls 4a of the frame 4 and the retaining portions 4c, a plurality of concave portion 4e are formed in the outer surfaces of the side walls 4a by sticking out the frame 4 inwards from the exterior, thereby constituting a plurality of solder-rise preventing means H.

Other constructional points are the same as in the above first embodiment, so the same components as in the first embodiment are here identified by the same reference numerals as in the first embodiment and explanations thereof will be omitted.

In this second embodiment, since solder-rise preventing means H are constituted by the concave portions 4e between the retaining portions 4c and the circuit board 1, the rise of the solder 5 is prevented by the solder-rise preventing means H upon melting of the creamy solder and the solder 5 does not reach the retaining portions 4c, as shown in Fig. 3. Consequently, the engaging holes 6c and the retaining portions 4c are firmly engaged with each other and there is no fear of disengagement of the cover 6 nor is there any fear of the cover becoming unengageable.

As set forth above, in the transmitter-receiver unit according to the present invention, since the solder-rise preventing means H are formed between the circuit board 1 and the retaining portions 4c, the rise of the solder 5 is prevented by the solder-rise preventing means H and the solder 5 does not reach the retaining portions 4c. Consequently, in comparison with the prior art, the engagement between the engaging holes 6c and the retaining portions 4c is ensured.

Moreover, even if the side walls 4a between the retaining portions 4c and the circuit board 1 are made short to meet the requirement for the reduction of size and weight of a portable telephone, the presence of the solder-rise preventing means H prevents the solder 5 from rising up to the retaining portions 4c and thus the solder 5 does not reach the retaining portions 4c. Consequently, the engagement between the engaging holes 6c and the retaining portions 4c is ensured and the transmitter-receiver unit so constructed is suitable for the reduction of size and weight.

Further, since the solder-rise preventing means H are formed by the convex portions 4d on the frame 4, there can be provided a transmitter-receiver unit whose construction is simple and which is high in productivity and less expensive.

Likewise, since the solder-rise preventing means H are formed by the concave portions 4e in the frame 4, there can be provided a transmitter-receiver unit which is simple in construction, high in productivity and less expensive.

## Claims

1. A transmitter-receiver unit comprising:
a circuit board (1) having electrically conductive patterns (2);
a metallic frame (4) having a plurality of retaining portions (4c), the metallic frame (4) being surface-mounted onto the circuit board (1); and
a cover (6) which covers the upper opening (4b) of the frame (4) and which is engaged with said retaining portions (4c),
**characterized in that** the frame is moreover provided with solder-rise preventing means (H) between the circuit board (1) and said plurality of retaining portions (4c).

2. A transmitter-receiver unit according to claim 1, wherein the solder-rise preventing means consist in convex portions provided on the frame.

3. A transmitter-receiver unit according to claim 1, wherein the solder-rise preventing means consist in concave portions provided in the frame.

## Patentansprüche

1. Eine Sende-Empfangseinheit umfassend:
Eine Leiterplatte (1) mit elektrisch leitenden Leiterbildern (2);
einen Metallrahmen (4) mit einer Mehrheit von Halteabschnitten (4c), wobei der Metallrahmen (4) auf der Leiterplatte (1) oberflächenmontiert ist; und
eine Abdeckung (6), welche die obere Öffnung (4b) des Rahmens (4) abdeckt und die mit besagten Halteabschnitten (4c) in Eingriff ist,
**dadurch gekennzeichnet, dass** der Rahmen überdies mit Verhinderungsmitteln (H) für Lotanstieg zwischen der Leiterplatte (1) und besagter Mehrheit von Halteabschnitten (4c) versehen ist.

2. Eine Sende-Empfangseinheit nach Anspruch 1, wobei das Verhinderungsmittel für Lotanstieg in konvexen Abschnitten besteht, die am Rahmen vorgesehen sind.

3. Eine Sende-Empfangseinheit nach Anspruch 1, wobei das Verhinderungsmittel für Lotanstieg in konkaven Abschnitten besteht, die im Rahmen vorgesehen sind.

## Revendications

1. Unité émettrice-réceptrice comportant :
une carte de circuit imprimé (1) ayant des impressions électriquement conductrices (2) ;
un châssis métallique (4) ayant une pluralité de portions de retenue (4c), le châssis métallique (4) étant monté en surface sur la carte de circuit imprimé (1) ; et
un couvercle (6) qui recouvre l'ouverture supérieure (4b) du châssis (4) et qui est enclenché avec lesdites portions de retenue (4c),
**caractérisée en ce que** le châssis est par ailleurs muni de moyens empêchant toute remontée de soudure (H) entre la carte de circuit imprimé (1) et ladite pluralité de portions de retenue (4c).

2. Unité émettrice-réceptrice selon la revendication 1, dans laquelle les moyens empêchant toute remontée de soudure sont composés de portions convexes mises en oeuvre sur le châssis.

3. Unité émettrice réceptrice selon la revendication 1, dans laquelle les moyens empêchant toute remontée de soudure sont composés de portions concaves mises en oeuvre dans le châssis.
